# EUROPEAN PATENT APPLICATION

(11) **EP 4 654 793 A1**
(43) Date of publication of application: **26.11.2025**
(21) Application number: 25178083.9
(22) Date of filing: 21.05.2025
(51) Int. Cl.: H10K 50/13, H10K 59/122, H10K 59/80

(54) **DISPLAY DEVICE, METHOD OF MANUFACTURING THE DISPLAY DEVICE, AND ELECTRONIC DEVICE INCLUDING THE DISPLAY DEVICE**

(30) Priority: 24.05.2024 KR 20240067820
(71) Applicant: Samsung Display Co., Ltd., Yongin-si, Gyeonggi-do 17113 (KR)
(72) Inventor: SONG, Il Ha, 17113 Yongin-si (KR); KIM, Sang Gyun, 17113 Yongin-si (KR)
(74) Representative: Marks & Clerk LLP

(57) **Abstract**

A display device includes: a first anode electrode on a pixel circuit layer; a first resonance auxiliary structure on the first anode electrode, and having a first thickness; a first connection electrode covering a side surface of the first resonance auxiliary structure and a portion of an upper surface of the first resonance auxiliary structure adjacent to the side surface of the first resonance auxiliary structure, the first connection electrode electrically contacting the first anode electrode; and a first sub-anode electrode covering the first connection electrode and a first exposed surface of the first resonance auxiliary structure that is not covered by the first connection electrode.

## Description

### BACKGROUND

### 1. Field

Aspects of embodiments of the present disclosure relate to a display device, a method of manufacturing the display device, and an electronic device including the display device.

### 2. Description of the Related Art

An organic light emitting display device is a self-emission kind of display device that displays an image using an organic light emitting element (e.g., an organic light emitting diode) for emitting light.

Generally, the organic light emitting element includes an anode electrode, a cathode electrode facing the anode electrode, and at least one organic light emitting layer interposed between the anode electrode and the cathode electrode. A hole supplied from the anode electrode and an electron supplied from the cathode electrode may combine with each other in the organic light emitting layer to form an exciton. The organic light emitting element generates light using energy generated when the exciton falls to a ground state.

The above information disclosed in this Background section is for enhancement of understanding of the background of the present disclosure, and therefore, it may contain information that does not constitute prior art.

### SUMMARY

A micro resonance (e.g., a microcavity) may be used as a method for improving a light efficiency by effectively extracting light generated from an organic light emitting layer. In the micro resonance, a strong interference effect may occur as light is repeatedly reflected by a first reflective layer (for example, such as an anode electrode) and a second reflective layer (for example, such as a cathode electrode) that are spaced apart (e.g., separated) from each other by a suitable distance (e.g., a preset or predefined distance). In this case, light of a desired wavelength (e.g., a specific or predetermined wavelength) may be amplified, and light of other wavelengths may be offset.

Embodiments of the present disclosure may be directed to a display device including a micro resonance and having an improved driving efficiency, and a method of manufacturing the display device.

According to one or more embodiments of the present disclosure, a display device includes: a first anode electrode on a pixel circuit layer; a first resonance auxiliary structure on the first anode electrode, and having a first thickness; a first connection electrode covering a side surface of the first resonance auxiliary structure and a portion of an upper surface of the first resonance auxiliary structure adjacent to the side surface of the first resonance auxiliary structure, the first connection electrode electrically contacting the first anode electrode; and a first sub-anode electrode covering the first connection electrode and a first exposed surface of the first resonance auxiliary structure that is not covered by the first connection electrode.

In an embodiment, a thickness of the first connection electrode may be greater than a thickness of the first sub-anode electrode.

In an embodiment, the first resonance auxiliary structure may have a trapezoidal shape in a cross-sectional view, in which a length of an upper side thereof may be shorter than a length of a lower side thereof.

In an embodiment, the first resonance auxiliary structure may include an inorganic insulating material.

In an embodiment, in a plan view, an edge of the first anode electrode may surround around an edge of the first resonance auxiliary structure.

In an embodiment, the first connection electrode may entirely cover an upper surface of the first anode electrode that does not overlap with the first resonance auxiliary structure.

In an embodiment, the display device may further include a pixel defining layer on the pixel circuit layer, and having a first pixel opening exposing a portion of the first sub-anode electrode.

In an embodiment, in a plan view, an edge of the first exposed surface may surround around an edge of the first pixel opening.

In an embodiment, the display device may further include a light emitting layer entirely on the pixel defining layer and the portion of the first sub-anode electrode exposed by the first pixel opening.

In an embodiment, the light emitting layer may include: a first common layer; an organic light emitting stack layer on the first common layer; and a second common layer on the organic light emitting stack layer.

In an embodiment, the organic light emitting stack layer may include: a first organic light emitting layer configured to emit a first light; a second organic light emitting layer on the first organic light emitting layer, and configured to emit a second light; and a third organic light emitting layer on the second organic light emitting layer, and configured to emit a third light.

In an embodiment, the display device may further include: a second anode electrode on the pixel circuit layer, and spaced from the first anode electrode; a second resonance auxiliary structure on the second anode electrode, and having a second thickness; a second connection electrode covering a side surface of the second resonance auxiliary structure and a portion of an upper surface of the second resonance auxiliary structure adjacent to the side surface of the second resonance auxiliary structure, the second connection electrode electrically contacting the second anode electrode; and a second sub-anode electrode covering the second connection electrode and a second exposed surface of the second resonance auxiliary structure that is not covered by the second connection electrode.

In an embodiment, the second thickness may be greater than the first thickness.

In an embodiment, a thickness of the second connection electrode may be greater than a thickness of the second sub-anode electrode.

In an embodiment, the display device may further include: a third anode electrode on the pixel circuit layer, and spaced from the first and second anode electrodes; a third resonance auxiliary structure on the third anode electrode, and having a third thickness; a third connection electrode covering a side surface of the third resonance auxiliary structure and a portion of an upper surface of the third resonance auxiliary structure adjacent to the side surface of the third resonance auxiliary structure, the third connection electrode electrically contacting the third anode electrode; and a third sub-anode electrode covering the third connection electrode and a third exposed surface of the third resonance auxiliary structure that is not covered by the third connection electrode.

In an embodiment, the third thickness may be greater than the second thickness.

In an embodiment, a thickness of the third connection electrode may be greater than a thickness of the third sub-anode electrode.

According to one or more embodiments of the present disclosure, a method of manufacturing a display device, includes: forming a first anode electrode on a pixel circuit layer; forming a first resonance auxiliary structure having a first thickness on the first anode electrode; forming a first connection electrode covering a side surface of the first resonance auxiliary structure and a portion of an upper surface of the first resonance auxiliary structure adjacent to the side surface of the first resonance auxiliary structure, the first connection electrode electrically contacting the first anode electrode; and forming a first sub-anode electrode covering the first connection electrode and a first exposed surface of the first resonance auxiliary structure that is not covered by the first connection electrode.

In an embodiment, the forming of the first connection electrode may include: forming a preliminary-connection electrode layer entirely covering the first resonance auxiliary structure and an upper surface of the first anode electrode that does not overlap with the first resonance auxiliary structure; and forming the first connection electrode to expose the first exposed surface of the first resonance auxiliary structure, by removing a portion of the preliminary-connection electrode layer.

In an embodiment, a thickness of the preliminary-connection electrode layer may be greater than a thickness of the first sub-anode electrode.

According to one or more embodiments of the present disclosure, an electronic device includes: a processor to provide input image data, and a display device to display an image based on the input image data. The display device includes: a first anode electrode on a pixel circuit layer; a first resonance auxiliary structure on the first anode electrode, and having a first thickness; a first connection electrode covering a side surface of the first resonance auxiliary structure and a portion of an upper surface of the first resonance auxiliary structure adjacent to the side surface of the first resonance auxiliary structure, the first connection electrode electrically contacting the first anode electrode; and a first sub-anode electrode covering the first connection electrode and a first exposed surface of the first resonance auxiliary structure that is not covered by the first connection electrode.

According to some embodiments of the present disclosure, a first connection electrode may cover an upper edge of a first resonance auxiliary structure. In other words, the first connection electrode may be located (e.g., may be interposed) between the first sub-anode electrode and the upper edge of the first resonance auxiliary structure.

In this case, the first connection electrode may serve as a buffer for preventing the first sub-anode electrode from being disconnected by the upper edge of the first resonance auxiliary structure having a relatively great taper angle. Accordingly, because the first sub-anode electrode may not be disconnected in an area adjacent to the upper edge of the first resonance auxiliary structure, a driving efficiency may be improved or may be prevented from being reduced.

At least some of the above and other features of the invention are set out in the claims.

However, the present disclosure is not limited to the above aspects and features, and the above and additional aspects and features will be set forth, in part, in the detailed description that follows with reference to the drawings, and in part, may be apparent therefrom, or may be learned by practicing one or more of the presented embodiments of the present disclosure.

### BRIEF DESCRIPTION OF THE DRAWINGS

The above and other aspects and features of the present disclosure will be more clearly understood from the following detailed description of the illustrative, nonlimiting embodiments with reference to the accompanying drawings, in which:
FIG. 1 is a block diagram illustrating a display device according to some embodiments of the present disclosure;
FIG. 2 is a block diagram illustrating one sub-pixel from among sub-pixels of the display device of FIG. 1;
FIG. 3 is a plan view illustrating a display panel of the display device of FIG. 1;
FIG. 4 is a cross-sectional view illustrating the display panel of FIG. 3, according to an embodiment;
FIG. 5 is a cross-sectional view illustrating the display panel of FIG. 3, according to an embodiment;
FIGS. 6-8 are plan views illustrating an embodiment of one pixel from among pixels of the display panel of FIG. 3;
FIG. 9 is a cross-sectional view taken along the line l1-l2 of FIG. 8;
FIG. 10 is a cross-sectional view taken along the line l2-l3 of FIG. 8;
FIG. 11 is a cross-sectional view taken along the line l3-l4 of FIG. 8;
FIGS. 12-16 are cross-sectional views illustrating a method of manufacturing a display device, according to an embodiment of the present disclosure;
FIG. 17 is a block diagram illustrating a display system according to an embodiment of the present disclosure; and
FIGS. 18-21 are perspective views illustrating various application examples of the display system of FIG. 17.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. Relative positions may be defined relative to the substrate (e.g. relative to an upper surface of the substrate). For instance, features that are "above" other features, may be located further away from the substrate in a vertical direction (e.g. in a direction perpendicular to the substrate (e.g. perpendicular to the upper surface of the substrate)). Similarly, "upper" features may be above "lower" features. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Further, it should be expected that the shapes shown in the figures may vary in practice depending, for example, on tolerances and/or manufacturing techniques. Accordingly, the embodiments of the present disclosure should not be construed as being limited to the specific shapes shown in the figures, and should be construed considering changes in shapes that may occur, for example, as a result of manufacturing. As such, the shapes shown in the drawings may not depict the actual shapes of areas of the device, and the present disclosure is not limited thereto.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another (e.g. that intersect each other).

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

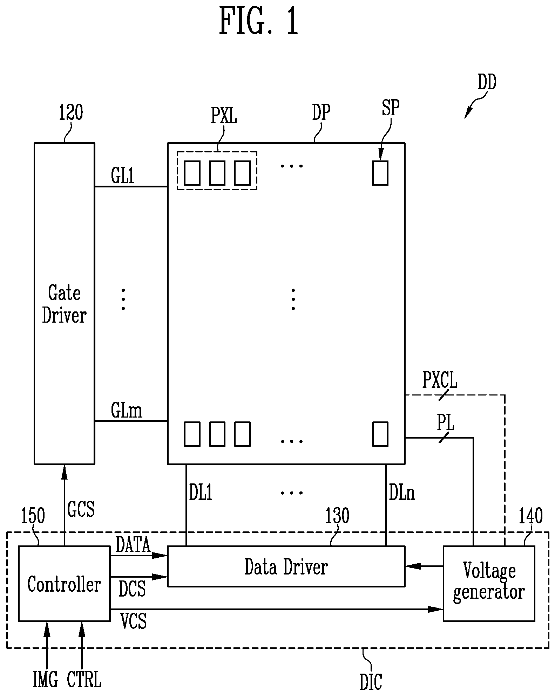

FIG. 1 is a block diagram illustrating a display device according to some embodiments of the present disclosure.

Referring to FIG. 1, the display device DD may include a display panel DP, a gate driver 120, a data driver 130, a voltage generator 140, and a controller 150.

The display panel DP may include sub-pixels SP. The sub-pixels SP may be connected to the gate driver 120 through first to m-th gate lines GL1 to GLm, where m is a natural number. The sub-pixels SP may be connected to the data driver 130 through first to n-th data lines DL1 to DLn, where n is a natural number.

The sub-pixels SP may generate light of two or more colors. For example, each of the sub-pixels SP may generate light of a suitable color, such as red, green, blue, cyan, magenta, or yellow.

Two or more sub-pixels SP from among the sub-pixels SP may configure one pixel PXL. For example, the pixel PXL may include three sub-pixels SP as shown in FIG. 1. The pixel PXL may emit light of various desired colors and various desired luminances according to a combination of the light emitted from the sub-pixels SP included in the pixel PXL.

The gate driver 120 may be connected to the sub-pixels SP arranged in a row direction through the first to m-th gate lines GL1 to GLm. The gate driver 120 may output gate signals to the first to m-th gate lines GL1 to GLm in response to a gate control signal GCS. In some embodiments, the gate control signal GCS may include a start signal indicating a start of each frame, a horizontal synchronization signal, and the like.

The gate driver 120 may be disposed on one side of the display panel DP. However, the present disclosure is not limited thereto. For example, the gate driver 120 may be divided into two or more physically and/or logically divided drivers, and the drivers may be disposed on one side of the display panel DP, and on another side of the display panel DP opposite to the one side. As described above, the gate driver 120 may be disposed around the display panel DP in various suitable shapes according to some embodiments.

The data driver 130 is connected to the sub-pixels SP arranged in a column direction through the first to n-th data lines DL1 to DLn. The data driver 130 receives image data DATA and a data control signal DCS from the controller 150. The data driver 130 operates in response to the data control signal DCS. In some embodiments, the data control signal DCS may include a source start signal, a source shift clock, a source output enable signal, and the like.

The data driver 130 may receive voltages from the voltage generator 140. The data driver 130 may apply data signals having grayscale voltages (e.g., grayscale values or levels) corresponding to the image data DATA to the first to n-th data lines DL1 to DLn using the received voltages. When the gate signal is applied to each of the first to m-th gate lines GL1 to GLm, the data signals corresponding to the image data DATA may be applied to the data lines DL1 to DLn. Accordingly, the sub-pixels SP may generate light corresponding to the data signals, and the display panel DP may display an image.

In some embodiments, the gate driver 120 and the data driver 130 may include complementary metal-oxide semiconductor (CMOS) circuit elements.

The voltage generator 140 may operate in response to a voltage control signal VCS from the controller 150. The voltage generator 140 may generate a plurality of voltages, and may provide the generated voltages to the components of the display device DD, such as the gate driver 120, the data driver 130, and the controller 150. The voltage generator 140 may generate the plurality of voltages by receiving an input voltage from the outside of the display device DD, and regulating the received input voltage.

The voltage generator 140 may generate a first power voltage and a second power voltage. The generated first and second power voltages may be provided to the sub-pixels SP through power lines PL. In another embodiment, at least one of the first or second power voltages may be provided from the outside of the display device DD.

In addition, the voltage generator 140 may provide various suitable voltages and/or signals. For example, the voltage generator 140 may provide one or more initialization voltages to be applied to the sub-pixels SP. For example, during a sensing operation for sensing electrical characteristics of transistors and/or light emitting elements of the sub-pixels SP, a reference voltage (e.g., a predetermined reference voltage) may be applied to the first to n-th data lines DL1 to DLn. In this case, the voltage generator 140 may generate the reference voltage and transmit the reference voltage to the data driver 130. For example, during a display operation for displaying an image on the display panel DP, common pixel control signals may be applied to the sub-pixels SP, and the voltage generator 140 may generate the pixel control signals. In some embodiments, the voltage generator 140 may provide the pixel control signals to the sub-pixels SP through pixel control lines PXCL. In FIG. 1, the pixel control lines PXCL are connected between the voltage generator 140 and the display panel DP, but the present disclosure is not limited thereto. For example, the pixel control lines PXCL may be connected between the gate driver 120 and the display panel DP. In this case, the pixel control signals may be transmitted from the voltage generator 140 to the pixel control lines PXCL through the gate driver 120.

The controller 150 controls the overall operations of the display device DD. The controller 150 receives input image data IMG and a control signal CTRL corresponding to the input image data IMG from the outside. The controller 150 may provide the gate control signal GCS, the data control signal DCS, and the voltage control signal VCS, in response to the control signal CTRL.

The controller 150 may convert the input image data IMG to be suitable for the display device DD or the display panel DP, and output the image data DATA. In some embodiments, the controller 150 may output the image data DATA by aligning the input image data IMG to be suitable for the sub-pixels SP of a row unit (e.g., in a unit of a row).

Two or more components from among the data driver 130, the voltage generator 140, and/or the controller 150 may be mounted on one integrated circuit (IC). As shown in FIG. 1, the data driver 130, the voltage generator 140, and the controller 150 may be included in a driver integrated circuit DIC. In this case, the data driver 130, the voltage generator 140, and the controller 150 may be functionally divided components in one (e.g., in the same) driver integrated circuit DIC. In other embodiments, at least one of the data driver 130, the voltage generator 140, or the controller 150 may be provided as a component distinguished or different from the driver integrated circuit DIC.

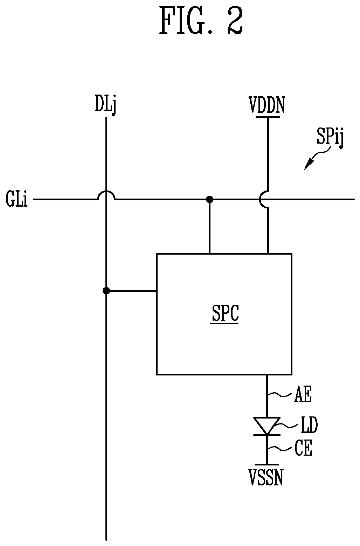

FIG. 2 is a block diagram illustrating one sub-pixel from among the sub-pixels of the display device of FIG. 1. In FIG. 2, from among the sub-pixels SP of FIG. 1, a sub-pixel SPij arranged in an i-th row (where i is an integer greater than or equal to 1 and less than or equal to m) and a j-th column (where j is an integer greater than or equal to 1 and less than or equal to n) is shown as a representative example.

Referring to FIG. 2, the sub-pixel SPij may include a sub-pixel circuit SPC and a light emitting element LD.

The light emitting element LD may be connected between a first power voltage node VDDN and a second power voltage node VSSN. The first power voltage node VDDN may be connected to one of the power lines PL described above with reference to FIG. 1, and receives the first power voltage. The second power voltage node VSSN may be connected to another one of the power lines PL described above with reference to FIG. 1, and receives the second power voltage. The first power voltage may have a voltage level higher than that of the second power voltage.

The light emitting element LD may be connected between an anode electrode AE and a cathode electrode CE. The anode electrode AE may be connected to the first power voltage node VDDN through the sub-pixel circuit SPC. For example, the anode electrode AE may be connected to the first power voltage node VDDN through one or more transistors included in the sub-pixel circuit SPC. The cathode electrode CE may be connected to the second power voltage node VSSN. The light emitting element LD may emit light according to a current flowing from the anode electrode AE to the cathode electrode CE.

The sub-pixel circuit SPC may be connected to an i-th gate line GLi from among the first to m-th gate lines GL1 to GLm described above with reference to FIG. 1, and a j-th data line DLj from among the first to n-th data lines DL1 to DLn. In response to a gate signal received through the i-th gate line GLi, the sub-pixel circuit SPC may control the light emitting element LD to emit light according to a data signal received through the j-th data line DLj. In some embodiments, the sub-pixel circuit SPC may be further connected to the pixel control lines PXCL described above with reference to FIG. 1. In this case, the sub-pixel circuit SPC may control the light emitting element LD further in response to the pixel control signals received through the pixel control lines PXCL.

For such operations, the sub-pixel circuit SPC may include circuit elements, for example, such as the transistors and one or more capacitors.

The transistors of the sub-pixel circuit SPC may include P-type transistors and/or N-type transistors. In some embodiments, the transistors of the sub-pixel circuit SPC may include a metal oxide semiconductor field effect transistor (MOSFET). In some embodiments, the transistors of the sub-pixel circuit SPC may include an amorphous silicon semiconductor, a monocrystalline silicon semiconductor, a polycrystalline silicon semiconductor, an oxide semiconductor, and/or the like.

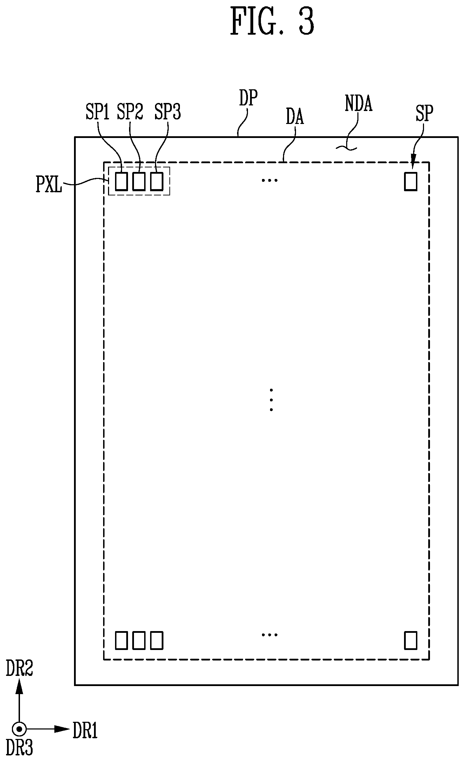

FIG. 3 is a plan view illustrating the display panel of the display device of FIG. 1.

Referring to FIG. 3, the display panel DP may include a display area DA and a non-display area NDA. The display panel DP may display an image through the display area DA. The non-display area NDA may be disposed around the display area DA.

The display panel DP may include the sub-pixels SP disposed in the display area DA. The sub-pixels SP may be arranged along a first direction DR1 and a second direction DR2 crossing the first direction DR1. For example, the sub-pixels SP may be arranged in a matrix form along the first direction DR1 and the second direction DR2. As another example, the sub-pixels SP may be arranged in a zigzag form along the first direction DR1 and the second direction DR2. An arrangement of the sub-pixels SP may be variously modified as needed or desired. The first direction DR1 may be a row direction, and the second direction DR2 may be a column direction. As another example, the first direction DR1 may be the column direction, and the second direction DR2 may be the row direction. The first direction DR1 and the second direction DR2 may be parallel to an upper surface of the substrate. The first direction DR1 and the second direction DR2 may define a horizontal plane.

Two or more sub-pixels from among the sub-pixels SP may configure one pixel PXL. In FIG. 3, the pixel PXL includes three sub-pixels SP1, SP2, and SP3, but the present disclosure is not limited thereto. For example, the pixel PXL may include two sub-pixels. Hereinafter, for convenience of illustration, the pixel PXL including the first to third sub-pixels SP1, SP2, and SP3 will be described in more detail as a representative example.

Each of the first to third sub-pixels SP1, SP2, and SP3 may include at least one light emitting element LD (e.g., refer to FIG. 2) and a sub-pixel circuit SPC to generate light. For example, the light emitting elements of the first to third sub-pixels SP1, SP2, and SP3 may generate blue, green, and/or red light.

A component for controlling the sub-pixels SP may be disposed in the non-display area NDA. Lines connected to the sub-pixels SP, for example, the first to m-th gate lines GL1 to GLm described above with reference to FIG. 1, the first to n-th data lines DL1 to DLn, the power lines PL, and the pixel control lines PXCL, may be disposed in the non-display area NDA.

At least one of the gate driver 120, the data driver 130, the voltage generator 140, and/or the controller 150 described above with reference to FIG. 1 may be disposed in the non-display area NDA of the display panel DP. In some embodiments, the gate driver 120 may be disposed in the non-display area NDA. In this case, the data driver 130, the voltage generator 140, and the controller 150 may be implemented as the driver integrated circuit DIC described above with reference to FIG. 1, which is separate from the display panel DP, and the driver integrated circuit DIC may be connected to the lines disposed in the non-display area NDA. In other embodiments, the gate driver 120 may be implemented as one integrated circuit separate from the display panel DP, together with the data driver 130, the voltage generator 140, and the controller 150.

In some embodiments, the display area DA may have various suitable shapes. The display area DA may have a closed loop shape including sides of a straight line and/or a curved line. For example, the display area DA may have shapes of a polygon, a circle, a semicircle, an ellipse, and the like.

In some embodiments, the display panel DP may have a flat or substantially flat display surface. In other embodiments, the display panel DP may have a display surface that is at least partially round or rounded. In some embodiments, the display panel DP may be bendable, foldable, or rollable. In these cases, the display panel DP and/or a substrate of the display panel DP may include one or more suitable materials having a flexible property.

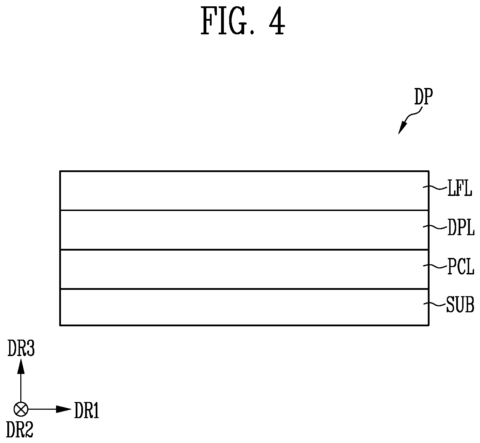

FIG. 4 is a cross-sectional view illustrating the display panel of FIG. 3, according to an embodiment.

Referring to FIG. 4, the display panel DP may include a substrate SUB. The display panel DP may further include a pixel circuit layer PCL, a display element layer DPL, and a light functional layer LFL sequentially stacked on the substrate SUB in a third direction DR3 crossing the first and second directions DR1 and DR2. The third direction DR3 may be perpendicular to the first and second direction DR1 and DR2. The third direction DR3 may be perpendicular to an upper surface of the substrate SUB. The third direction DR3 may define a vertical direction.

The substrate SUB may include (e.g., may be formed of) an insulating material, such as glass or a resin. For example, the substrate SUB may include a glass substrate. As another example, the substrate SUB may include a polyimide (PI) substrate. As another example, the substrate SUB may include a silicon wafer substrate formed using a semiconductor process.

In some embodiments, the substrate SUB may be formed of a flexible material that may be bent or folded, and may have a single-layer structure or a multi-layered structure. For example, the flexible material may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and/or cellulose acetate propionate. However, the present disclosure is not limited thereto.

The pixel circuit layer PCL may be disposed on the substrate SUB. The pixel circuit layer PCL may include insulating layers, and semiconductor patterns and conductive patterns disposed between the insulating layers. The conductive patterns of the pixel circuit layer PCL may function as the circuit elements, the lines, and the like.

The circuit elements of the pixel circuit layer PCL may configure the sub-pixel circuit SPC of each of the sub-pixels SP described above with reference to FIG. 3. In other words, the circuit elements of the pixel circuit layer PCL may include the transistors and the one or more capacitors of the sub-pixel circuit SPC.

The lines of the pixel circuit layer PCL may include lines connected to the sub-pixels SP. The lines of the pixel circuit layer PCL may include various signal lines and/or voltage lines used to drive the display element layer DPL.

The display element layer DPL may be disposed on the pixel circuit layer PCL. The display element layer DPL may include the light emitting elements of the sub-pixels SP.

The light functional layer LFL may be disposed on the display element layer DPL. The light functional layer LFL may include light conversion patterns having color conversion particles and/or scattering particles. For example, the color conversion particles may include quantum dots. The quantum dots may change a wavelength (e.g., a color) of light emitted from the display element layer DPL. The light functional layer LFL may further include light scattering patterns including the scattering particles. In some embodiments, the light conversion patterns and the light scattering patterns may be omitted as needed or desired.

The light functional layer LFL may further include a color filter layer including color filters. The color filter may selectively transmit light of a desired wavelength (e.g., a specific or predetermined wavelength or color). In some embodiments, the color filter layer may be omitted as needed or desired.

A window for protecting an exposed surface (e.g., an upper surface) of the display panel DP may be provided on the light functional layer LFL. The window may protect the display panel DP from external shock. The window may be connected to (e.g., coupled to or attached to) the light functional layer LFL through an optically transparent adhesive (or cohesive) member. The window may have a multi-layered structure selected from among a glass substrate, a plastic film, and/or a plastic substrate. The multi-layered structure may be formed through a continuous process, or an adhesion process using an adhesive layer. All of or a portion of the window may be flexible.

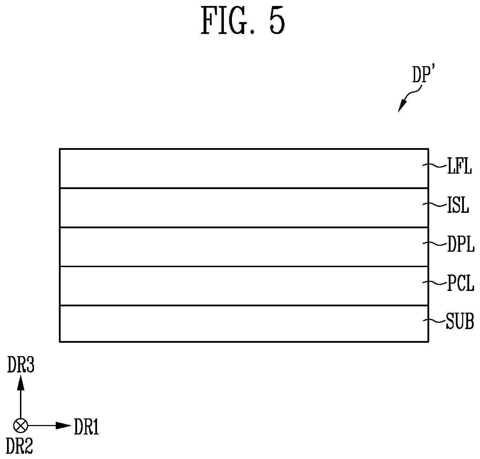

FIG. 5 is a cross-sectional view illustrating the display panel of FIG. 3, according to an embodiment.

Referring to FIG. 5, the display panel DP' may include the substrate SUB, the pixel circuit layer PCL, the display element layer DPL, an input sensing layer ISL, and the light functional layer LFL. The substrate SUB, the pixel circuit layer PCL, the display element layer DPL, and the light functional layer LFL may be the same or substantially the same as (or similar to) the substrate SUB, the pixel circuit layer PCL, the display element layer DPL, and the light functional layer LFL described above with reference to FIG. 5, and thus, redundant description thereof may not be repeated.

The input sensing layer ISL may sense a user's input on an upper surface (e.g., on a display surface) of the display panel DP'. The input sensing layer ISL may include components suitable for sensing an external object, such as a user's hand or a pen. For example, the input sensing layer ISL may include touch electrodes.

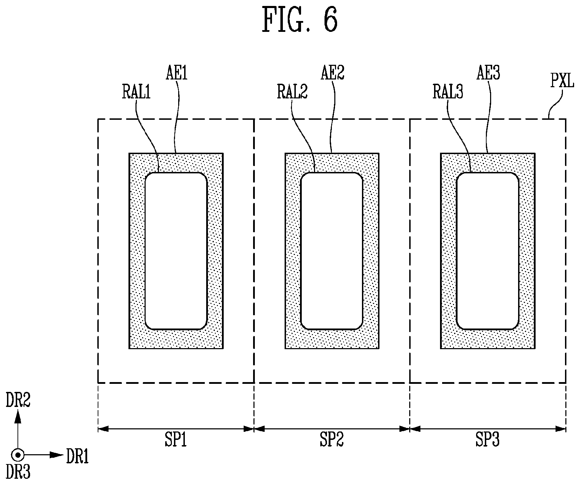

FIGS. 6 through 8 are plan views illustrating an embodiment of one pixel from among the pixels of the display panel of FIG. 3.

Referring to FIG. 6, the pixel PXL may include the first to third sub-pixels SP1, SP2, and SP3. The first to third sub-pixels SP1, SP2, and SP3 may be arranged along the first direction DR1. However, the arrangement of the first to third sub-pixels SP1, SP2, and SP3 is not limited thereto, and may be variously modified as needed or desired. For example, the first to third sub-pixels SP1, SP2, and SP3 may be arranged in a zigzag shape. Generally, the first to third sub-pixels SP1, SP2, and SP3 may be spaced apart from each other in one or more horizontal directions (e.g. one or more directions that are parallel to a plane defined by the first direction DR1 and the second direction DR2).

First to third anode electrodes AE1, AE2, and AE3 may be disposed in the first to third sub-pixels SP1, SP2, and SP3, respectively. The first anode electrode AE1 may be provided as the anode electrode AE (e.g., refer to FIG. 2) connected to the sub-pixel circuit SPC of the first sub-pixel SP1. The second anode electrode AE2 may be provided as the anode electrode AE connected to the sub-pixel circuit SPC of the second sub-pixel SP2. The third anode electrode AE3 may be provided as the anode electrode AE connected to the sub-pixel circuit SPC of the third sub-pixel SP3.

A first resonance auxiliary structure RAL1 may be disposed on the first anode electrode AE1. The first resonance auxiliary structure RAL1 may completely overlap with a portion of the first anode electrode AE1 in a plan view. A plan view may be a view along the third direction DR3. In an embodiment, an edge of the first anode electrode AE1 may surround (e.g., around a periphery of) an edge of the first resonance auxiliary structure RAL1 in a plan view.

A second resonance auxiliary structure RAL2 may be disposed on the second anode electrode AE2. The second resonance auxiliary structure RAL2 may completely overlap with a portion of the second anode electrode AE2 in a plan view. In an embodiment, an edge of the second anode electrode AE2 may surround (e.g., around a periphery of) an edge of the second resonance auxiliary structure RAL2 in a plan view.

A third resonance auxiliary structure RAL3 may be disposed on the third anode electrode AE3. The third resonance auxiliary structure RAL3 may completely overlap with a portion of the third anode electrode AE3 in a plan view. In an embodiment, an edge of the third anode electrode AE3 may surround (e.g., around a periphery of) an edge of the third resonance auxiliary structure RAL3 in a plan view.

The first to third resonance auxiliary structures RAL1, RAL2, and RAL3 may serve to improve a light efficiency of the pixel PXL by inducing a micro resonance of the light of a desired wavelength (e.g., a specific or predetermined wavelength).

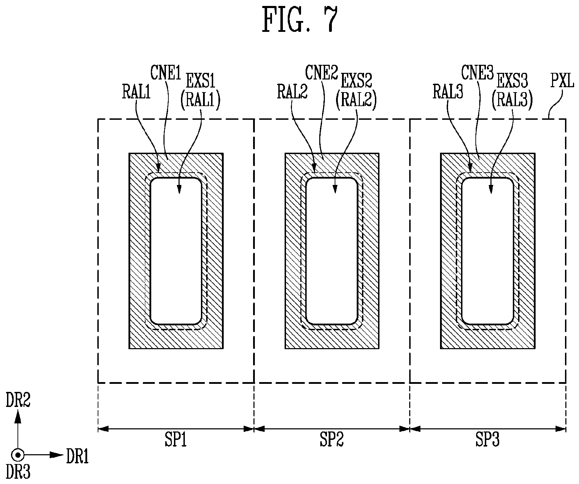

Referring to FIG. 7, a first connection electrode CNE1 may be disposed on the first anode electrode AE1 (e.g., refer to FIG. 6) and the first resonance auxiliary structure RAL1. The first connection electrode CNE1 may expose a portion of the first resonance auxiliary structure RAL1. For example, the first resonance auxiliary structure RAL1 may have a first exposed surface EXS1 that does not overlap with the first connection electrode CNE1 in a plan view. In this case, in a plan view, an edge of the first exposed surface EXS1 may be surrounded (e.g., around a periphery thereof) by the edge of the first resonance auxiliary structure RAL1. The first exposed surface EXS1 may be a central portion of the upper surface of the first resonance auxiliary structure RAL1.

A second connection electrode CNE2 may be disposed on the second anode electrode AE2 (e.g., refer to FIG. 6) and the second resonance auxiliary structure RAL2. The second connection electrode CNE2 may expose a portion of the second resonance auxiliary structure RAL2. For example, the second resonance auxiliary structure RAL2 may have a second exposed surface EXS2 that does not overlap with the second connection electrode CNE2 in a plan view. In this case, in a plan view, an edge of the second exposed surface EXS2 may be surrounded (e.g., around a periphery thereof) by the edge of the second resonance auxiliary structure RAL2. The second exposed surface EXS2 may be a central portion of the upper surface of the second resonance auxiliary structure RAL2.

A third connection electrode CNE3 may be disposed on the third anode electrode AE3 (e.g., refer to FIG. 6) and the third resonance auxiliary structure RAL3. The third connection electrode CNE3 may expose a portion of the third resonance auxiliary structure RAL3. For example, the third resonance auxiliary structure RAL3 may have a third exposed surface EXS3 that does not overlap with the third connection electrode CNE3 in a plan view. In this case, in a plan view, an edge of the third exposed surface EXS3 may be surrounded (e.g., around a periphery thereof) by the edge of the third resonance auxiliary structure RAL3. The third exposed surface EXS3 may be a central portion of the upper surface of the third resonance auxiliary structure RAL3.

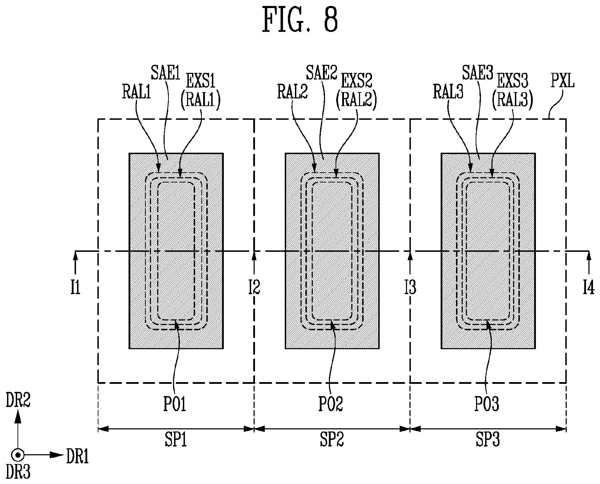

Referring to FIG. 8, a first sub-anode electrode SAE1 may be disposed on the first connection electrode CNE1 (e.g., refer to FIG. 7) and the first resonance auxiliary structure RAL1. The first sub-anode electrode SAE1 may cover the first exposed surface EXS1 of the first resonance auxiliary structure RAL1.

A second sub-anode electrode SAE2 may be disposed on the second connection electrode CNE2 (e.g., refer to FIG. 7) and the second resonance auxiliary structure RAL2. The second sub-anode electrode SAE2 may cover the second exposed surface EXS2 of the second resonance auxiliary structure RAL2.

A third sub-anode electrode SAE3 may be disposed on the third connection electrode CNE3 (e.g., refer to FIG. 7) and the third resonance auxiliary structure RAL3. The third sub-anode electrode SAE3 may cover the third exposed surface EXS3 of the third resonance auxiliary structure RAL3.

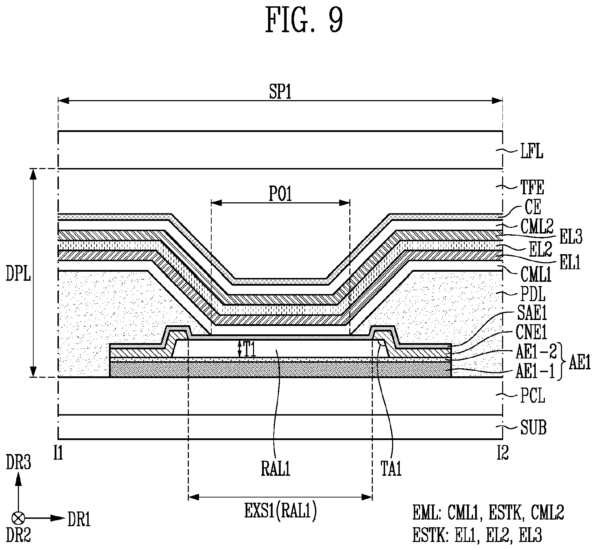

FIG. 9 is a cross-sectional view taken along the line 11-12 of FIG. 8. FIG. 9 is a cross-sectional view illustrating a first sub-pixel SP1 of FIG. 8.

Referring to FIGS. 6 to 9, the pixel circuit layer PCL, the display element layer DPL, and the light functional layer LFL may be sequentially disposed (e.g. stacked) on the substrate SUB (e.g. on the upper surface of the substrate SUB).

The pixel circuit layer PCL may include insulating layers, semiconductor patterns, and conductive patterns, which are stacked on the substrate SUB. The semiconductor patterns and the conductive patterns may be interposed between the insulating layers. The conductive patterns may include, for example, at least one of copper (Cu), molybdenum (Mo), tungsten (W), aluminum neodymium (AINd), titanium (Ti), aluminum (Al), and/or silver (Ag).

The sub-pixel circuit SPC (e.g., refer to FIG. 2) of the first sub-pixel SP1 may include transistors and one or more capacitors. The semiconductor patterns and the conductive patterns of the pixel circuit layer PCL may function as the transistors and the capacitors of the sub-pixel circuit SPC. In addition, the conductive patterns of the pixel circuit layer PCL may further function as lines, for example, such as the first to m-th gate lines GL1 to GLm, the first to n-th data lines DL1 to DLn, the power lines PL, and the pixel control lines PXCL described above with reference to FIG. 1.

The display element layer DPL may be disposed on the pixel circuit layer PCL. The display element layer DPL may include the first anode electrode AE1, the first resonance auxiliary structure RAL1, the first connection electrode CNE1, the first sub-anode electrode SAE1, the pixel defining layer PDL, the light emitting layer EML, the cathode electrode CE, and the encapsulation layer TFE.

The first anode electrode AE1 may be disposed on the pixel circuit layer PCL. The first anode electrode AE1 may be electrically connected to at least one transistor from among the transistors of the sub-pixel circuit SPC of the first sub-pixel SP1.

In an embodiment, the first anode electrode AE1 may include a (1-1)-th anode electrode AE1-1 and a (1-2)-th anode electrode AE1-2, which are sequentially stacked along the third direction DR3. The (1-1)-th anode electrode AE1-1 may be otherwise known as a first first anode electrode AE1-1. The (1-2)-th anode electrode AE1-2 may be otherwise known as a second first anode electrode AE1-2.

The (1-1)-th anode electrode AE1-1 may be formed of a conductive material having a suitable reflectance (e.g., a predetermined reflectance). For instance, the (1-1)-th anode electrode AE1-1 may be formed of a conductive material having a suitable reflectance when combined with the (1-2)-th anode electrode AE1-2 (e.g. at an interface between the (1-1)-th anode electrode AE1-1 and the (1-2)-th anode electrode AE1-2). For example, the (1-1)-th anode electrode AE1-1 may include an opaque metal. The opaque metal may include at least one selected from the group consisting of silver (Ag), magnesium (Mg), aluminum (Al), platinum (Pt), palladium (Pd), gold (Au), nickel (Ni), neodymium (Nd), iridium (Ir), chromium (Cr), titanium (Ti), and a suitable alloy thereof. However, the material of the (1-1)-th anode electrode AE1-1 is not limited thereto.

The (1-2)-th anode electrode AE1-2 may be substantially transparent or translucent to satisfy a desired light transmittance (e.g., a predetermined light transmittance). For example, the (1-2)-th anode electrode AE1-2 may include a light-transmitting metal oxide. For example, the (1-2)-th anode electrode AE1-2 may include at least one selected from the group consisting of indium tin oxide (ITO), indium zinc oxide (IZO), zinc oxide (ZnO), indium gallium zinc oxide (IGZO), and indium tin zinc oxide (ITZO). As another example, the (1-2)-th anode electrode AE1-2 may include a light-transmitting metal nitride (e.g., TiN). However, the material of the (1-2)-th anode electrode AE1-2 is not limited thereto.

The first resonance auxiliary structure RAL1 may be disposed on the first anode electrode AE1. The first resonance auxiliary structure RAL1 may include a light-transmitting insulating material. For example, the first resonance auxiliary structure RAL1 may include an inorganic insulating material, such as silicon oxide, silicon nitride, or silicon oxynitride. However, the material of the first resonance auxiliary structure RAL1 is not limited thereto.

The first resonance auxiliary structure RAL1 may serve to adjust an optimal resonance efficiency of light emitted from a first organic light emitting layer EL1 included in the light emitting layer EML. In an embodiment, the first resonance auxiliary structure RAL1 may have a first thickness T1 in the third direction DR3. First light emitted from the first organic light emitting layer EL1 may resonate between a reflective interface between the (1-1)-th anode electrode AE1-1 and a layer (e.g., AE1-2) that is in contact with the (1-1)-th anode electrode AE1-1, and a reflective interface between the cathode electrode CE and a layer (e.g., CML2) that is in contact with the cathode electrode CE. The first thickness T1 may be an appropriate thickness for compensating for a resonance distance of the first light.

In an embodiment, the first resonance auxiliary structure RAL1 may have a trapezoidal shape in a cross-sectional view (e.g. a view along a horizontal direction, such as the first direction DR1), in which a length of an upper side thereof is shorter than a length of a lower side thereof. In this case, as shown in FIG. 9, a first taper angle TA1 between a side surface and an upper surface of the first resonance auxiliary structure RAL1 may be defined. The first taper angle TA1 may be about 90 degrees or more (e.g. greater than or equal to 90 degrees) and about 180 degrees or less (e.g. less than or equal to 180 degrees), for example, such as about 120 degrees or more (e.g. greater than or equal to 120 degrees) and about 140 degrees or less (e.g. less than or equal to 140 degrees) in some embodiments.

The first connection electrode CNE1 may cover the side surface of the first resonance auxiliary structure RAL1 and a portion of the upper surface adjacent to the side surface. The first connection electrode CNE1 may electrically contact the first anode electrode AE1. For example, the first connection electrode CNE1 may directly contact the entire or substantially entire upper surface of the first anode electrode AE1 that does not overlap with the first resonance auxiliary structure RAL1. The first connection electrode CNE1 may include a conductive material. The first connection electrode CNE1 may include a light-transmitting conductive material. For example, the first connection electrode CNE1 may include a metal, a light-transmitting metal oxide, and/or a light-transmitting metal nitride.

The first connection electrode CNE1 may not cover (e.g. may expose) another portion of the upper surface of the first resonance auxiliary structure RAL1. In the upper surface of the first resonance auxiliary structure RAL1, an exposed surface, which is not covered by the first connection electrode CNE1, may be defined as the first exposed surface EXS1. The terms "expose" and "exposed" in this context may refer to how the first exposed surface EXS1 is not covered by the first connection electrode CNE1, however, it will be appreciated that the first exposed surface EXS1, whilst being exposed by the first connection electrode CNE1, may still be covered by other layers of the device, as described below.

The first sub-anode electrode SAE1 may be disposed on the first connection electrode CNE1 and the first resonance auxiliary structure RAL1. The first sub-anode electrode SAE1 may cover the first connection electrode CNE1 and the first exposed surface EXS1. In this case, the first sub-anode electrode SAE1 may electrically contact the first connection electrode CNE1. Therefore, the first sub-anode electrode SAE1 may be electrically connected to the first anode electrode AE1 through the first connection electrode CNE1. The first sub-anode electrode SAE1 may be substantially transparent or translucent to satisfy a desired light transmittance (e.g., a predetermined light transmittance). For example, the first sub-anode electrode SAE1 may include a suitable material that is the same or substantially the same as (or similar to) that of the (1-2)-th anode electrode AE1-2.

The first connection electrode CNE1 may cover an upper edge of the first resonance auxiliary structure RAL1 where the first taper angle TA1 is defined. In other words, the first connection electrode CNE1 may be interposed between the first sub-anode electrode SAE1 and the upper edge of the first resonance auxiliary structure RAL1. The first connection electrode CNE1 may serve as a buffer for preventing the first sub-anode electrode SAE1 from being disconnected due to the relatively great first taper angle TA1. Accordingly, the first sub-anode electrode SAE1 may not be disconnected in an area adjacent to the upper edge of the first resonance auxiliary structure RAL1. As such, a driving efficiency reduction of the first sub-pixel SP1 may be prevented or substantially prevented.

In an embodiment, a thickness of the first connection electrode CNE1 may be greater than a thickness of the first sub-anode electrode SAE1. For example, the thickness of the first connection electrode CNE1 may be about 1.5 times or more than (e.g. greater than or equal to 1.5 times) the thickness of the first sub-anode electrode SAE1. As the first connection electrode CNE1 has a relatively greater thickness, the first connection electrode CNE1 may not be disconnected in an area adjacent to the upper edge of the first resonance auxiliary structure RAL1.

The pixel defining layer PDL may be disposed on the pixel circuit layer PCL and the first sub-anode electrode SAE1. The pixel defining layer PDL may define a first pixel opening PO1 exposing a portion of the first sub-anode electrode SAE1. In an embodiment, as shown in FIG. 8, an edge of the first exposed surface EXS1 may surround (e.g., around a periphery of) an edge of the first pixel opening PO1 in a plan view. In other words, as shown in FIG. 9, the pixel defining layer PDL may be disposed to cover the first connection electrode CNE1 in a cross-sectional view.

The pixel defining layer PDL may include a light blocking material, and may serve to prevent light mixing between adjacent sub-pixels. For example, the pixel defining layer PDL may include an organic insulating material, such as an acryl resin, an epoxy resin, a phenol resin, a polyamide resin, and/or a polyimide resin.

The light emitting layer EML may be entirely disposed on the pixel defining layer PDL and the first sub-anode electrode SAE1 exposed by the first pixel opening PO1. The light emitting layer EML may include a first common layer CML1, an organic light emitting stack layer ESTK, and a second common layer CML2.

The first common layer CML1 may include various suitable functional layers for improving an efficiency of light emitted from the organic light emitting stack layer ESTK. For example, the first common layer CML1 may include a hole injection layer and a hole transport layer sequentially stacked along the third direction DR3. However, a kind of the functional layers included in the first common layer CML1 is not limited thereto.

The organic light emitting stack layer ESTK may be disposed on the first common layer CML1. The organic light emitting stack layer ESTK may have a stacked structure in which two or more organic light emitting layers for emitting light having different wavelengths from each other are stacked. In other words, the light emitting layer EML may be provided in a tandem structure.

In an embodiment, the organic light emitting stack layer ESTK may include a first organic light emitting layer EL1 for emitting a first light, a second organic light emitting layer EL2 disposed on the first organic light emitting layer EL1 and for emitting a second light, and a third organic light emitting layer EL3 disposed on the second organic light emitting layer EL2 and for emitting a third light. The first light, second light and third light may have different wavelengths. For example, the first light may be a blue light, the second light may be a green light, and the third light may be a red light.

The second common layer CML2 may be disposed on the organic light emitting stack layer ESTK. The second common layer CML2 may include various suitable functional layers for improving an efficiency of light emitted from the light emitting stack layer ESTK. For example, the second common layer CML2 may include an electron transport layer and an electron injection layer sequentially stacked along the third direction DR3. However, a kind of the functional layers included in the second common layer CML2 is not limited thereto.

The first common layer CML1, the light emitting stack layer ESTK, and the second common layer CML2 may define the light emitting element LD of the first sub-pixel SP1 (e.g., refer to FIG. 2).

The cathode electrode CE may be disposed on the second common layer CML2. The cathode electrode CE may be substantially translucent. For example, the cathode electrode CE may include a metal oxide. For example, the cathode electrode CE may include at least one selected from the group consisting of indium tin oxide (ITO), indium zinc oxide (IZO), zinc oxide (ZnO), indium gallium zinc oxide (IGZO), and indium tin zinc oxide (ITZO). However, the material of the cathode electrode CE is not limited thereto.

The encapsulation layer TFE may be disposed on the cathode electrode CE. The encapsulation layer TFE may serve to protect the components under the encapsulation layer TFE from an impurity (e.g., moisture and/or gas). For example, the encapsulation layer TFE may include a first inorganic encapsulation layer, an organic encapsulation layer, and a second inorganic encapsulation layer sequentially stacked along the third direction DR3.

The light functional layer LFL may be disposed on the encapsulation layer TFE. The light functional layer LFL may include light conversion patterns having color conversion particles and/or scattering particles, and/or a color filter layer including color filters. In an embodiment, in an area where the first sub-pixel SP1 is provided, the light functional layer LFL may include a blue color filter that selectively transmits a blue color light. However, the light functional layer LFL is not limited thereto.

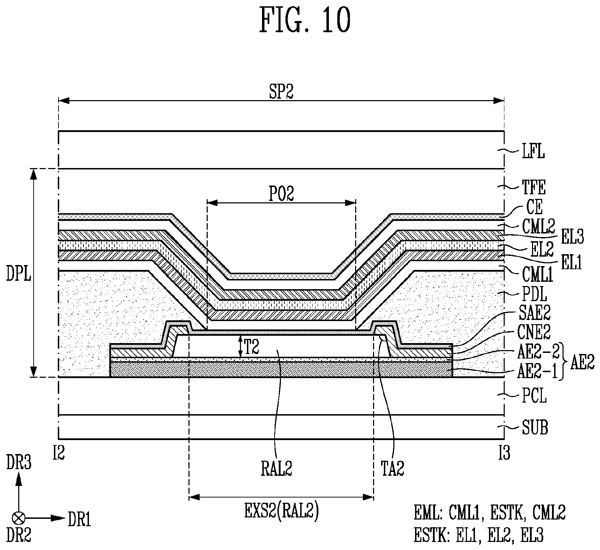

FIG. 10 is a cross-sectional view taken along the line l2-l3 of FIG. 8. FIG. 10 is a cross-sectional view illustrating the second sub-pixel described above with reference to FIG. 8.

Referring to FIGS. 6 to 8 and FIG. 10, the pixel circuit layer PCL, the display element layer DPL, and the light functional layer LFL may be sequentially disposed on the substrate SUB.

The pixel circuit layer PCL may be the same or substantially the same as (or similar to) the pixel circuit layer PCL described above with reference to FIG. 9. For example, the pixel circuit layer PCL may include various suitable components configuring the sub-pixel circuit SPC of the second sub-pixel SP2 (e.g., refer to FIG. 2).

The display element layer DPL may be disposed on the pixel circuit layer PCL. The display element layer DPL may include the second anode electrode AE2, the second resonance auxiliary structure RAL2, the second connection electrode CNE2, the second sub-anode electrode SAE2, the pixel defining layer PDL, the light emitting layer EML, the cathode electrode CE, and the encapsulation layer TFE.

The second anode electrode AE2 may be disposed on the pixel circuit layer PCL. The second anode electrode AE2 may be electrically connected to at least one transistor from among the transistors of the sub-pixel circuit SPC of the second sub-pixel SP2.

In an embodiment, the second anode electrode AE2 may include a (2-1)-th anode electrode AE2-1 and a (2-2)-th anode electrode AE2-2 sequentially stacked along the third direction DR3. The (2-1)-th anode electrode AE2-1 may be referred to as a first second anode electrode AE2-1 and the (2-2)-th anode electrode AE2-2 may be referred to as a second second anode electrode AE22.

The (2-1)-th anode electrode AE2-1 may be formed of a conductive material having a suitable reflectance (e.g., a predetermined reflectance). For instance, the (2-1)-th anode electrode AE2-1 may be formed of a conductive material having a suitable reflectance when combined with the (2-2)-th anode electrode AE2-2 (e.g. at an interface between the (2-1)-th anode electrode AE2-1 and the (2-2)-th anode electrode AE2-2). For example, the (2-1)-th anode electrode AE2-1 may include a material that is the same or substantially the same as (or similar to) that of the (1-1)-th anode electrode AE1-1 (e.g., refer to FIG. 9).

The (2-2)-th anode electrode AE2-2 may be substantially transparent or translucent to satisfy a desired light transmittance (e.g., a predetermined light transmittance). For example, the (2-2)-th anode electrode AE2-2 may include a material that is the same or substantially the same as (or similar to) that of the (1-2)-th anode electrode AE1-2 (e.g., refer to FIG. 9).

The second resonance auxiliary structure RAL2 may be disposed on the second anode electrode AE2. The second resonance auxiliary structure RAL2 may include a light-transmitting insulating material. For example, the second resonance auxiliary structure RAL2 may include an inorganic insulating material, such as silicon oxide, silicon nitride, or silicon oxynitride. However, the material of the second resonance auxiliary structure RAL2 is not limited thereto.

The second resonance auxiliary structure RAL2 may serve to adjust an optimal resonance efficiency of light emitted from the second organic light emitting layer EL2 included in the light emitting layer EML. In an embodiment, the second resonance auxiliary structure RAL2 may have a second thickness T2 in the third direction DR3. Second light emitted from the second organic light emitting layer EL2 may resonate between a reflective interface between the (2-1)-th anode electrode AE2-1 and a layer (e.g., AE2-2) that is in contact with the (2-1)-th anode electrode AE2-1, and a reflective interface between the cathode electrode CE and a layer (e.g., CML2) that is in contact with the cathode electrode CE. The second thickness T2 may be an appropriate thickness for compensating for a resonance distance of the second light. For example, the second thickness T2 may be greater than the first thickness T1 (e.g., refer to FIG. 9).

In an embodiment, the second resonance auxiliary structure RAL2 may have a trapezoidal shape in a cross-sectional view, in which a length of an upper side thereof is less than a length of a lower side thereof. In this case, as shown in FIG. 10, a second taper angle TA2 between a side surface and an upper surface of the second resonance auxiliary structure RAL2 may be defined. In some embodiments, the second taper angle TA2 may be about 90 degrees or more (e.g. greater than or equal to 90 degrees) and about 180 degrees or less (e.g. less than or equal to 180 degrees), and in an embodiment, may be about 120 degrees or more (e.g. greater than or equal to 120 degrees) and about 140 degrees or less (e.g. less than or equal to 140 degrees).

The second connection electrode CNE2 may cover the side surface of the second resonance auxiliary structure RAL2 and a portion of the upper surface adjacent to the side surface. The second connection electrode CNE2 may electrically contact the second anode electrode AE2. For example, the second connection electrode CNE2 may directly contact the entire or substantially entire upper surface of the second anode electrode AE2 that does not overlap with the second resonance auxiliary structure RAL2. The second connection electrode CNE2 may include a conductive material. The second connection electrode CNE2 may include a light-transmitting conductive material. For example, the second connection electrode CNE2 may include an opaque metal and/or a light-transmitting metal oxide.

The second connection electrode CNE2 may not cover another portion of the upper surface of the second resonance auxiliary structure RAL2. In the upper surface of the second resonance auxiliary structure RAL2, an exposed surface, which is not covered by the second connection electrode CNE2, may be defined as the second exposed surface EXS2.

The second sub-anode electrode SAE2 may be disposed on the second connection electrode CNE2 and the second resonance auxiliary structure RAL2. The second sub-anode electrode SAE2 may cover the second connection electrode CNE2 and the second exposed surface EXS2. In this case, the second sub-anode electrode SAE2 may electrically contact the second connection electrode CNE2. Therefore, the second sub-anode electrode SAE2 may be electrically connected to the second anode electrode AE2 through the second connection electrode CNE2. The second sub-anode electrode SAE2 may be substantially transparent or translucent to satisfy a desired light transmittance (e.g., a predetermined light transmittance). For example, the second sub-anode electrode SAE2 may include a material that is the same or substantially the same as (or similar to) that of the (2-2)-th anode electrode AE2-2.

In some embodiments, the second connection electrode CNE2 may cover an upper edge of the second resonance auxiliary structure RAL2 where the second taper angle TA2 is defined. In other words, the second connection electrode CNE2 may be interposed between the second sub-anode electrode SAE2 and the upper edge of the second resonance auxiliary structure RAL2. The second connection electrode CNE2 may serve as a buffer for preventing the second sub-anode electrode SAE2 from being disconnected due to the relatively great second taper angle TA2. Accordingly, the second sub-anode electrode SAE2 may not be disconnected in an area adjacent to the upper edge of the second resonance auxiliary structure RAL2. Accordingly, a driving efficiency reduction of the second sub-pixel SP2 may be prevented or substantially prevented.

In an embodiment, a thickness of the second connection electrode CNE2 may be greater than a thickness of the second sub-anode electrode SAE2. For example, the thickness of the second connection electrode CNE2 may be about 1.5 times or more than (e.g. greater than or equal to 1.5 times) the thickness of the second sub-anode electrode SAE2. As the second connection electrode CNE2 has a relatively greater thickness, the second connection electrode CNE2 may not be disconnected in an area adjacent to the upper edge of the second resonance auxiliary structure RAL2.

The pixel defining layer PDL may be the same or substantially the same as (or similar to) the pixel defining layer PDL described above with reference to FIG. 9. The pixel defining layer PDL may define a second pixel opening PO2 exposing a portion of the second sub-anode electrode SAE2. In an embodiment, as shown in FIG. 8, an edge of the second exposed surface EXS2 may surround (e.g., around a periphery of) an edge of the second pixel opening PO2 in a plan view. In other words, as shown in FIG. 10, the pixel defining layer PDL may be disposed to cover the second connection electrode CNE2 in a cross-sectional view.

The light emitting layer EML may be the same or substantially the same as (or similar to) the light emitting layer EML described above with reference to FIG. 9. The light emitting layer EML may be continuously provided throughout an area where the first sub-pixel SP1 (e.g., refer to FIG. 9) is provided and an area where the second sub-pixel SP2 is provided. In the area where the second sub-pixel SP2 is provided, the light emitting layer EML may define the light emitting element LD (e.g., refer to FIG. 2) of the second sub-pixel SP2.

The cathode electrode CE may be the same or substantially the same as (or similar to) the cathode electrode CE described above with reference to FIG. 9. The cathode electrode CE may be continuously provided throughout the area where the first sub-pixel SP1 (e.g., refer to FIG. 9) is provided and the area where the second sub-pixel SP2 is provided.

The encapsulation layer TFE may be the same or substantially the same as (or similar to) the encapsulation layer TFE described above with reference to FIG. 9. The encapsulation layer TFE may be continuously provided throughout the area where the first sub-pixel SP1 (e.g., refer to FIG. 9) is provided and the area where the second sub-pixel SP2 is provided.

The light functional layer LFL may be the same or substantially the same as (or similar to) the light functional layer LFL described above with reference to FIG. 9. In an embodiment, in the area where the second sub-pixel SP2 is provided, the light functional layer LFL may include a green color filter that selectively transmits a green color light. However, the light functional layer LFL is not limited thereto.

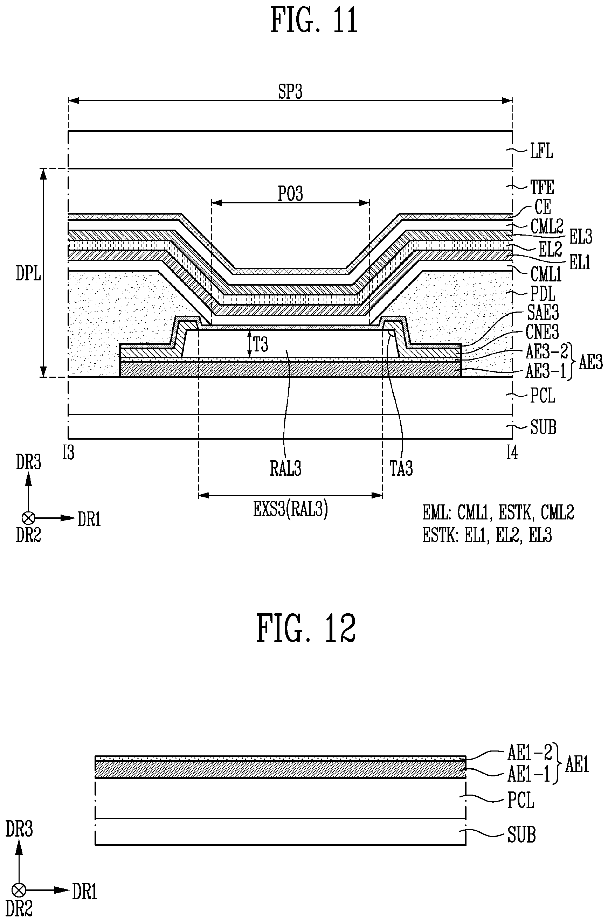

FIG. 11 is a cross-sectional view taken along line l3-l4 of FIG. 8. FIG. 11 is a cross-sectional view illustrating the third sub-pixel described above with reference to FIG. 8.

Referring to FIGS. 6 to 8 and 11, the pixel circuit layer PCL, the display element layer DPL, and the light functional layer LFL may be sequentially disposed on the substrate SUB.

The pixel circuit layer PCL may be the same or substantially the same as (or similar to) the pixel circuit layer PCL described above with reference to FIG. 9. For example, the pixel circuit layer PCL may include various suitable components configuring the sub-pixel circuit SPC of the third sub-pixel SP3 (e.g., refer to FIG. 2).

The display element layer DPL may be disposed on the pixel circuit layer PCL. The display element layer DPL may include the third anode electrode AE3, the third resonance auxiliary structure RAL3, the third connection electrode CNE3, the third sub-anode electrode SAE3, the pixel defining layer PDL, the light emitting layer EML, the cathode electrode CE, and the encapsulation layer TFE.

The third anode electrode AE3 may be disposed on the pixel circuit layer PCL. The third anode electrode AE3 may be electrically connected to at least one transistor from among the transistors configuring the sub-pixel circuit SPC of the third sub-pixel SP3.

In an embodiment, the third anode electrode AE3 may include a (3-1)-th anode electrode AE3-1 and a (3-2)-th anode electrode AE3-2 sequentially stacked along the third direction DR3. The (3-1)-th anode electrode AE3-1 may be referred to as a first third anode electrode AE3-1 and the (3-2)-th anode electrode AE3-2 may be referred to as a second third anode electrode AE32.

The (3-1)-th anode electrode AE3-1 may be formed of a conductive material having a suitable reflectance (e.g., a predetermined reflectance). For instance, the (3-1)-th anode electrode AE3-1 may be formed of a conductive material having a suitable reflectance when combined with the (3-2)-th anode electrode AE3-2 (e.g. at an interface between the (3-1)-th anode electrode AE3-1 and the (3-2)-th anode electrode AE3-2). For example, the (3-1)-th anode electrode AE3-1 may include a material that is the same or substantially the same as (or similar to) that of the (1-1)-th anode electrode AE1-1 (e.g., refer to FIG. 9).

The (3-2)-th anode electrode AE3-2 may be substantially transparent or translucent to satisfy a desired light transmittance (e.g., a predetermined light transmittance). For example, the (3-2)-th anode electrode AE3-2 may include a material that is the same or substantially the same as (or similar to) that of the (1-2)-th anode electrode AE1-2 (e.g., refer to FIG. 9).

The third resonance auxiliary structure RAL3 may be disposed on the third anode electrode AE3. The third resonance auxiliary structure RAL3 may include a light-transmitting insulating material. For example, the third resonance auxiliary structure RAL3 may include an inorganic insulating material, such as silicon oxide, silicon nitride, or silicon oxynitride. However, the material of the third resonance auxiliary structure RAL3 is not limited thereto.

The third resonance auxiliary structure RAL3 may serve to adjust an optimal resonance efficiency of light emitted from the third organic light emitting layer EL3 included in the light emitting layer EML. In an embodiment, the third resonance auxiliary structure RAL3 may have a third thickness T3 in the third direction DR3. Third light emitted from the third organic light emitting layer EL3 may resonate between a reflective interface between the (3-1)-th anode electrode AE3-1 and a layer (e.g., AE3-2) that is in contact with the (3-1)-th anode electrode AE3-1, and a reflective interface between the cathode electrode CE and a layer (e.g., CML2) that is in contact with the cathode electrode CE. The third thickness T3 may be an appropriate thickness for compensating for a resonance distance of the third light. For example, the third thickness T3 may be greater than the second thickness T2 (e.g., refer to FIG. 10).

In an embodiment, the third resonance auxiliary structure RAL3 may have a trapezoidal shape in a cross-sectional view, in which a length of an upper side thereof is less than a length of a lower side thereof. In this case, as shown in FIG. 11, a third taper angle TA3 between a side surface and an upper surface of the third resonance auxiliary structure RAL3 may be defined. In some embodiments, the third taper angle TA3 may be about 90 degrees or more (e.g. greater than or equal to 90 degrees) and about 180 degrees or less (e.g. less than or equal to 180 degrees), and in an embodiment, may be about 120 degrees or more (e.g. greater than or equal to 120 degrees) and about 140 degrees or less (e.g. less than or equal to 140 degrees).

The third connection electrode CNE3 may cover the side surface of the third resonance auxiliary structure RAL3 and a portion of the upper surface adjacent to the side surface. The third connection electrode CNE3 may electrically contact the third anode electrode AE3. For example, the third connection electrode CNE3 may directly contact the entire or substantially entire upper surface of the third anode electrode AE3 that does not overlap with the third resonance auxiliary structure RAL3. The third connection electrode CNE3 may include a conductive material. The third connection electrode CNE3 may include a light-transmitting conductive material. For example, the third connection electrode CNE3 may include an opaque metal and/or a light-transmitting metal oxide.

The third connection electrode CNE3 may not cover another portion of the upper surface of the third resonance auxiliary structure RAL3. In the upper surface of the third resonance auxiliary structure RAL3, an exposed surface, which is not covered by the third connection electrode CNE3, may be defined as the third exposed surface EXS3.

The third sub-anode electrode SAE3 may be disposed on the third connection electrode CNE3 and the third resonance auxiliary structure RAL3. The third sub-anode electrode SAE3 may cover the third connection electrode CNE3 and the third exposed surface EXS3. In this case, the third sub-anode electrode SAE3 may electrically contact the third connection electrode CNE3. Therefore, the third sub-anode electrode SAE3 may be electrically connected to the third anode electrode AE3 through the third connection electrode CNE3. The third sub-anode electrode SAE3 may be substantially transparent or translucent to satisfy a desired light transmittance (e.g., a predetermined light transmittance). For example, the third sub-anode electrode SAE3 may include a material that is the same or substantially the same as (or similar to) that of the (3-2)-th anode electrode AE3-2.

In some embodiments, the third connection electrode CNE3 may cover an upper edge of the third resonance auxiliary structure RAL3 where the third taper angle TA3 is defined. In other words, the third connection electrode CNE3 may be interposed between the third sub-anode electrode SAE3 and the upper edge of the third resonance auxiliary structure RAL3. The third connection electrode CNE3 may serve as a buffer for preventing the third sub-anode electrode SAE3 from being disconnected due to the relatively great third taper angle TA3. Accordingly, the third sub-anode electrode SAE3 may not be disconnected in an area adjacent to the upper edge of the third resonance auxiliary structure RAL3. Accordingly, a driving efficiency reduction of the third sub-pixel SP3 may be prevented or substantially prevented.

In an embodiment, a thickness of the third connection electrode CNE3 may be greater than a thickness of the third sub-anode electrode SAE3. For example, the thickness of the third connection electrode CNE3 may be about 1.5 times or more than (e.g. greater than or equal to 1.5 times) the thickness of the third sub-anode electrode SAE3. As the third connection electrode CNE3 has a relatively greater thickness, the third connection electrode CNE3 may not be disconnected in an area adjacent to the upper edge of the third resonance auxiliary structure RAL3.

The pixel defining layer PDL may be the same or substantially the same as (or similar to) the pixel defining layer PDL described above with reference to FIG. 9. The pixel defining layer PDL may define a third pixel opening PO3 exposing a portion of the third sub-anode electrode SAE3. In an embodiment, as shown in FIG. 8, an edge of the third exposed surface EXS3 may surround (e.g., around a periphery of) an edge of the third pixel opening PO3 in a plan view. In other words, as shown in FIG. 11, the pixel defining layer PDL may be disposed to cover the third connection electrode CNE3 in a cross-sectional view.

The light emitting layer EML may be the same or substantially the same as (or similar to) the light emitting layer EML described above with reference to FIG. 9. The light emitting layer EML may be continuously provided throughout areas where the first to third sub-pixels SP1, SP2, and SP3 are provided. In an area where the third sub-pixel SP3 is provided, the light emitting layer EML may define the light emitting element LD (e.g., refer to FIG. 2) of the third sub-pixel SP3.

The cathode electrode CE may be the same or substantially the same as (or similar to) the cathode electrode CE described above with reference to FIG. 9. The cathode electrode CE may be continuously provided throughout the areas where the first to third sub-pixels SP1, SP2, and SP3 are provided.

The encapsulation layer TFE may be the same or substantially the same as (or similar to) the encapsulation layer TFE described above with reference to FIG. 9. The encapsulation layer TFE may be continuously provided throughout the areas where the first to third sub-pixels SP1, SP2, and SP3 are provided.

The light functional layer LFL may be the same or substantially the same as (or similar to) the light functional layer LFL described above with reference to FIG. 9. In an embodiment, in the area where the third sub-pixel SP3 is provided, the light functional layer LFL may include a red color filter that selectively transmits a red color light. However, the light functional layer LFL is not limited thereto.

FIGS. 12 through 16 are cross-sectional views illustrating a method of manufacturing a display device, according to an embodiment of the present disclosure. Hereinafter, redundant description of the components described above with reference to FIGS. 1 to 11 may not be repeated.

Referring to FIG. 12, the first anode electrode AE1 may be formed on the pixel circuit layer PCL. The first anode electrode AE1 may include the (1-1)-th anode electrode AE1-1 and the (1-2)-th anode electrode AE1-2.

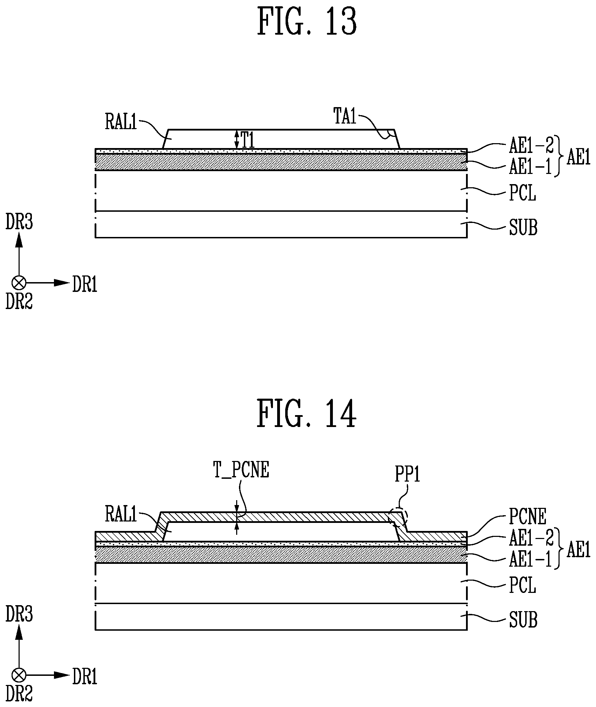

Referring to FIG. 13, the first resonance auxiliary structure RAL1 may be formed on the first anode electrode AE1. The first resonance auxiliary structure RAL1 may have the first thickness T1 in the third direction DR3, and may have the first taper angle TA1 of the upper edge.

Referring to FIG. 14, a preliminary-connection electrode layer PCNE covering the first resonance auxiliary structure RAL1 and the first anode electrode AE1 may be formed. The preliminary-connection electrode layer PCNE may have a relatively great thickness. For example, a thickness T_PCNE of the preliminary-connection electrode layer PCNE in the third direction DR3 may be greater than the thickness of the first sub-anode electrode SAE1 described above with reference to FIG. 9. For example, the thickness T_PCNE of the preliminary-connection electrode layer PCNE may be about 200 angstroms or more (e.g. greater than or equal to 200 angstroms) and about 300 angstroms or less (e.g. less than or equal to 300 angstroms). Accordingly, a portion PP1 of the preliminary-connection electrode layer PCNE adjacent to the upper edge of the first resonance auxiliary structure RAL1 may be prevented or substantially prevented from being disconnected.

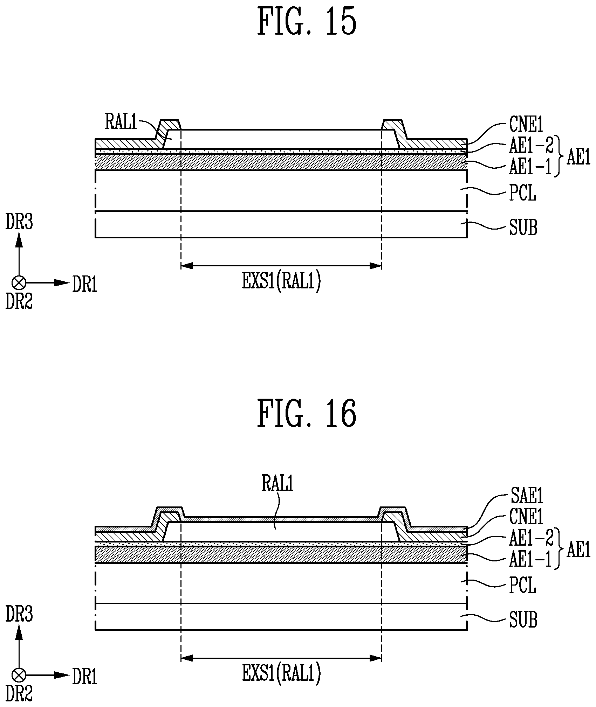

Referring to FIG. 15, a portion of the preliminary-connection electrode layer PCNE may be removed to form the first connection electrode CNE1 that exposes the first exposed surface EXS1 of the first resonance auxiliary structure RAL1.

Referring to FIG. 16, the first sub-anode electrode SAE1 covering the first connection electrode CNE1 and the first exposed surface EXS1 may be formed. Because the first connection electrode CNE1 covers the upper edge of the first resonance auxiliary structure RAL1, the first sub-anode electrode SAE1 may be prevented or substantially prevented from being disconnected by the relatively great first taper angle TA1 (e.g., refer to FIG. 13).

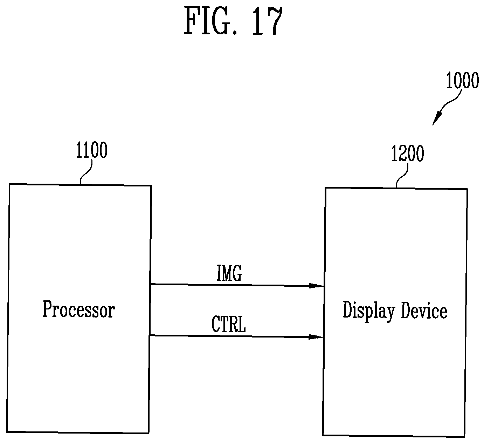

FIG. 17 is a block diagram illustrating a display system according to an embodiment of the present disclosure.

Referring to FIG. 17, the display system 1000 may include a processor 1100 and a display device 1200.

The processor 1100 may perform various suitable tasks and calculations. In some embodiments, the processor 1100 may include an application processor, a graphics processor, a microprocessor, a central processing unit (CPU), and/or the like. The processor 1100 may be connected to the other components of the display system 1000 through a bus system to control the other components.

The processor 1100 may transmit image data IMG and a control signal CTRL to the display device 1200. The display device 1200 may display an image based on the image data IMG and the control signal CTRL. The display device 1200 may be the same or substantially the same as (or similar to) the display device DD described above with reference to FIG. 1. In this case, the image data IMG and the control signal CTRL may be provided as the input image data IMG and the control signal CTRL described above with reference to FIG. 1, respectively.

The display system 1000 may include a computing system for providing an image display function, such as a smart watch, a mobile phone, a smart phone, a portable computer, a tablet personal computer (PC), a watch phone, an automotive display, smart glasses, a portable multimedia player (PMP), a navigation device, and/or an ultra mobile personal computer (UMPC). In addition, the display system 1000 may include at least one of a head mounted display (HMD) device, a virtual reality (VR) device, a mixed reality (MR) device, and/or an augmented reality (AR) device.

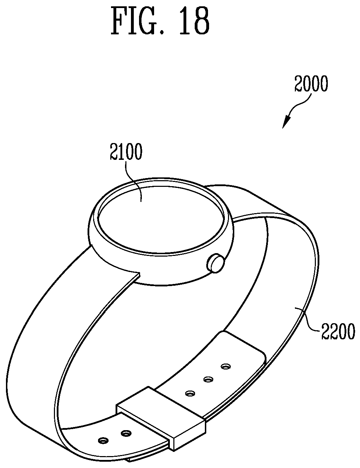

FIGS. 18 through 21 are perspective views illustrating various application examples of the display system of FIG. 17.

Referring to FIG. 18, the display system 1000 described above with reference to FIG. 17 may be applied to a smart watch 2000 including a display unit (e.g., a display or a touch-display) 2100 and a strap unit (e.g., a strap or a band) 2200.

The smart watch 2000 may be a wearable electronic device. For example, the smart watch 2000 may have a structure in which the strap unit 2200 is mounted on a user's wrist. The display system 1000 and/or the display device 1200 may be applied to the display unit 2100, and image data including time information may be provided to a user.

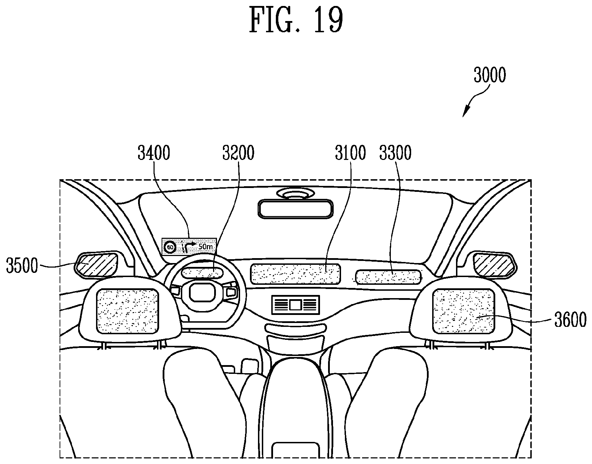

Referring to FIG. 19, the display system 1000 described above with reference to FIG. 17 may be applied to an automotive display system 3000. The automotive display system 3000 may include a computing system provided inside and/or outside a vehicle to provide image data.

For example, the display system 1000 and/or the display device 1200 may be applied to at least one of an infotainment panel 3100, a cluster 3200, a co-driver display 3300, a head-up display 3400, a side mirror display 3500, and/or a rear seat displays 3600 provided in a vehicle.

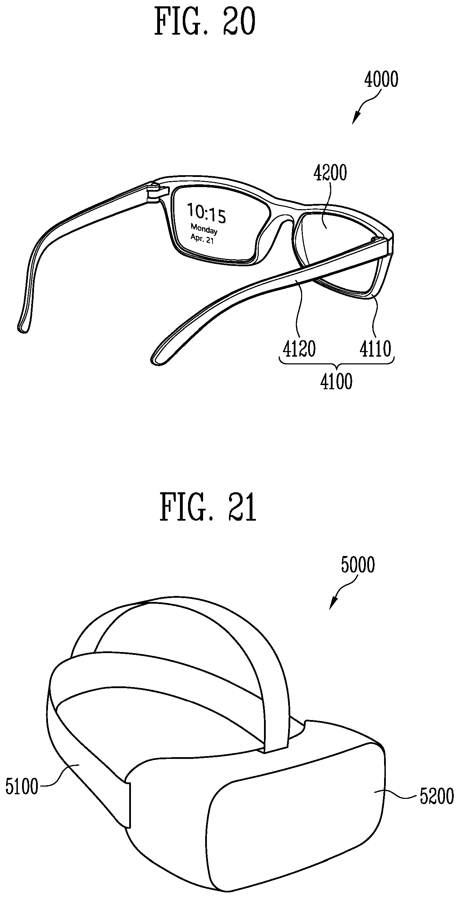

Referring to FIG. 20, the display system 1000 described above with reference to FIG. 17 may be applied to smart glasses 4000. The smart glasses 4000 may be a wearable electronic device that may be worn on a user's head. For example, the smart glasses 4000 may be a wearable device for augmented reality (AR).

The smart glasses 4000 may include a frame 4100 and a lens unit (e.g., a lens) 4200. The frame 4100 may include a housing 4110 that supports the lens unit 4200, and a leg unit (e.g., a leg or arm) 4120 for the user to wear. The leg unit 4120 may be connected to the housing 4110 through a hinge, and may be folded or unfolded relative to the housing 4110.

A battery, a touch pad, a microphone, a camera, and the like may be built in the frame 4100. In addition, a projector that outputs light, a processor that controls a light signal, and the like may be built in the frame 4100.

The lens unit 4200 may include an optical member that transmits or reflects light. For example, the lens unit 4200 may include glass, a transparent synthetic resin, or the like.

In order for user's eyes to recognize visual information, the lens unit 4200 may reflect an image by the light signal transmitted from the projector of the frame 4100 by a rear surface (e.g., a surface of a direction facing the user's eyes) of the lens unit 4200. For example, the user may recognize visual information, such as time and date, displayed on the lens unit 4200. The projector and/or the lens unit 4200 may be a kind of display device. The display device 1200 may be applied to the projector and/or the lens unit 4200.

Referring to FIG. 21, the display system 1000 described above with reference to FIG. 17 may be applied to a head mounted display device 5000.

The head mounted display device 5000 may be a wearable electronic device that may be worn on a user's head. For example, the head mounted display device 5000 may be a wearable device for virtual reality (VR) or mixed reality.

The head mounted display device 5000 may include a head mount band 5100 and a display device receiving case 5200. The head mount band 5100 may be connected to the display device receiving case 5200. The head mount band 5100 may include a horizontal band and/or a vertical band for fixing the head mounted display device 5000 to a user's head. The horizontal band may surround (e.g., around a periphery of) a side portion of the user's head, and the vertical band may surround (e.g., around a periphery of) an upper portion of the user's head. However, the present disclosure is not limited thereto. For example, the head mount band 5100 may be implemented in the form of a glasses frame, a helmet, or the like.

The display device receiving case 5200 may receive the display system 1000 and/or the display device 1200.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A display device comprising:
a first anode electrode on a pixel circuit layer;
a first resonance auxiliary structure on the first anode electrode, and having a first thickness;
a first connection electrode covering a side surface of the first resonance auxiliary structure and a portion of an upper surface of the first resonance auxiliary structure adjacent to the side surface of the first resonance auxiliary structure, the first connection electrode electrically contacting the first anode electrode; and
a first sub-anode electrode covering the first connection electrode and a first exposed surface of the first resonance auxiliary structure that is not covered by the first connection electrode.

2. The display device according to claim 1, wherein a thickness of the first connection electrode is greater than a thickness of the first sub-anode electrode.

3. The display device according to claim 1 or claim 2, wherein:
the first resonance auxiliary structure has a trapezoidal shape in a cross-sectional view, in which a length of an upper side thereof is shorter than a length of a lower side thereof; and/or
the first resonance auxiliary structure comprises an inorganic insulating material.

4. The display device according to any preceding claim, wherein:
in a plan view, an edge of the first anode electrode surrounds around an edge of the first resonance auxiliary structure; and/or
the first connection electrode entirely covers an upper surface of the first anode electrode that does not overlap with the first resonance auxiliary structure.

5. The display device according to any preceding claim, further comprising:
a pixel defining layer on the pixel circuit layer, and having a first pixel opening exposing a portion of the first sub-anode electrode.

6. The display device according to claim 5, wherein:
in a plan view, an edge of the first exposed surface surrounds around an edge of the first pixel opening; and/or
the display device further comprises a light emitting layer entirely on the pixel defining layer and the portion of the first sub-anode electrode exposed by the first pixel opening.

7. The display device according to claim 5, further comprising a light emitting layer entirely on the pixel defining layer and the portion of the first sub-anode electrode exposed by the first pixel opening, wherein the light emitting layer comprises:
a first common layer;
an organic light emitting stack layer on the first common layer; and
a second common layer on the organic light emitting stack layer, and
optionally, wherein the organic light emitting stack layer comprises:
a first organic light emitting layer configured to emit a first light;
a second organic light emitting layer on the first organic light emitting layer, and configured to emit a second light; and
a third organic light emitting layer on the second organic light emitting layer, and configured to emit a third light.

8. The display device according to any preceding claim, further comprising:
a second anode electrode on the pixel circuit layer, and spaced from the first anode electrode;
a second resonance auxiliary structure on the second anode electrode, and having a second thickness;
a second connection electrode covering a side surface of the second resonance auxiliary structure and a portion of an upper surface of the second resonance auxiliary structure adjacent to the side surface of the second resonance auxiliary structure, the second connection electrode electrically contacting the second anode electrode; and
a second sub-anode electrode covering the second connection electrode and a second exposed surface of the second resonance auxiliary structure that is not covered by the second connection electrode.

9. The display device according to claim 8, wherein:
the second thickness is greater than the first thickness; and/or
a thickness of the second connection electrode is greater than a thickness of the second sub-anode electrode.

10. The display device according to claim 8 or claim 9, further comprising:
a third anode electrode on the pixel circuit layer, and spaced from the first and second anode electrodes;
a third resonance auxiliary structure on the third anode electrode, and having a third thickness;
a third connection electrode covering a side surface of the third resonance auxiliary structure and a portion of an upper surface of the third resonance auxiliary structure adjacent to the side surface of the third resonance auxiliary structure, the third connection electrode electrically contacting the third anode electrode; and
a third sub-anode electrode covering the third connection electrode and a third exposed surface of the third resonance auxiliary structure that is not covered by the third connection electrode.

11. The display device according to claim 10, wherein:
the third thickness is greater than the second thickness; and/or
a thickness of the third connection electrode is greater than a thickness of the third sub-anode electrode.

12. A method of manufacturing a display device, the method comprising:
forming a first anode electrode on a pixel circuit layer;
forming a first resonance auxiliary structure having a first thickness on the first anode electrode;
forming a first connection electrode covering a side surface of the first resonance auxiliary structure and a portion of an upper surface of the first resonance auxiliary structure adjacent to the side surface of the first resonance auxiliary structure, the first connection electrode electrically contacting the first anode electrode; and
forming a first sub-anode electrode covering the first connection electrode and a first exposed surface of the first resonance auxiliary structure that is not covered by the first connection electrode.

13. The method according to claim 12, wherein the forming of the first connection electrode comprises:
forming a preliminary-connection electrode layer entirely covering the first resonance auxiliary structure and an upper surface of the first anode electrode that does not overlap with the first resonance auxiliary structure; and
forming the first connection electrode to expose the first exposed surface of the first resonance auxiliary structure, by removing a portion of the preliminary-connection electrode layer.

14. The method according to claim 13, wherein a thickness of the preliminary-connection electrode layer is greater than a thickness of the first sub-anode electrode.

15. An electronic device comprising:
a processor configured to provide input image data; and
a display device according to any of claims 1-11, wherein the display device is configured to display an image based on the input image data.
